# EUROPÄISCHE PATENTSCHRIFT

(11) **EP 2 646 841 B1**
(45) Veröffentlichungstag und Bekanntmachung des Hinweises auf die Patenterteilung: **04.05.2016**
(21) Anmeldenummer: 12715366.6
(22) Anmeldetag: 12.04.2012
(51) Int. Cl.: H02M 1/32, G01R 31/02

(54) **ISOLATIONSÜBERWACHUNG IN EINEM PHOTOVOLTAIKWECHSELRICHTER**
ISOLATION MONITORING IN A PHOTVOLTAIC INVERTER CIRCUIT
SURVEILLANCE DE L'ISOLEMENT DANS UN ONDULEUR PHOTOVOLTAÏQUE

(30) Priorität: 12.04.2011 DE 102011007222
(43) Veröffentlichungstag der Anmeldung: 09.10.2013
(73) Patentinhaber: KACO new energy GmbH, 74172 Neckarsulm (DE)
(72) Erfinder: SCHAUPP, Thomas, 74821 Mosbach (DE); DWORSKY, Matthias, 76275 Ettlingen (DE); SCHOOR, Michael, 70195 Stuttgart (DE); SINNER, Joachim, 76698 Ubstadt Weiher (DE); RÖSSER, Gerd, 34121 Kassel (DE)
(74) Vertreter: Patentanwälte Ruff, Wilhelm, Beier, Dauster & Partner mbB
(86) Internationale Anmeldenummer: PCT/EP2012/056694
(87) Internationale Veröffentlichungsnummer: WO 2012/140149

(56) Entgegenhaltungen:
- EP-A1- 1 315 264
- WO-A1-2010/029353
- DE-A1- 10 304 234
- DE-U1- 29 615 591

## Beschreibung

Die Erfindung betrifft eine Wechselrichterschaltung zur Umwandlung einer von einem Generator erzeugten Gleichspannung in eine Wechselspannung, einen die Wechselrichterschaltung enthaltenden Wechselrichter und ein den Wechselrichter enthaltendes Photovoltaiksystem.

Bei Photovoltaikanlagen wird eine von einem photovoltaischen Generator (PV-Generator) erzeugte Gleichspannung mittels eines Wechselrichters in eine Wechselspannung gewandelt, die zur Einspeisung in ein Wechselstromnetz dient.

Bei so genannten transformatorlosen Wechselrichtern ist es durch einschlägige gesetzliche Normen vorgeschrieben, den PV-Generator auf Isolationsfehler, d.h niederohmige Verbindungen gegen Prozesserde, zu überwachen. Diese Überwachung erfolgt mittels einer Isolationsüberwachungsschaltung, die vor einer Zuschaltung des Wechselrichters, üblicherweise in den Morgenstunden, die Isolationsüberwachung durchführt und bei Erkennen eines Isolationsfehlers ein Zuschalten des Wechselrichters verhindert, um eine Gefährdung und eine mögliche Beschädigung des Wechselrichters zu vermeiden.

Die Isolationsüberwachung umfasst üblicherweise einen Spannungsteiler mit bekanntem Widerstandsverhältnis, der einen hochohmigen Bezug zu Prozesserde herstellt. Entspricht eine Spannungsaufteilung am Spannungsteiler dem Widerstandsverhältnis, liegt in der Regel kein Isolationsfehler vor. Die Widerstände des Spannungsteilers werden üblicherweise mittels speziell hierfür vorgesehenen Messwiderständen realisiert. Da diese Methode einen blinden Bereich aufweist, d.h. Isolationsfehler an bestimmten Orten systematisch nicht detektieren kann, ist es notwendig, das Teilerverhältnis des Spannungsteilers zu variieren.

Herkömmlich sind hierzu dedizierte Schaltmittel, beispielsweise Relais, innerhalb des Wechselrichters vorgesehen, die ausschließlich dazu dienen, spezifisch hierfür vorgesehene Wiederstände zu- bzw. abzuschalten, um das Teilerverhältnis geeignet zu verändern.

Die europäische Patentanmeldung EP 1315264 A1 zeigt eine Schaltung nach dem Oberbegriff des Anspruchs 1.

Der Erfindung liegt die Aufgabe zugrunde, eine Wechselrichterschaltung zur Umwandlung einer von einem Generator erzeugten Gleichspannung in eine Wechselspannung mit einer Isolationsüberwachungsschaltung, einen Wechselrichter und ein Photovoltaiksystem zur Verfügung zu stellen, die eine zuverlässige Isolationsüberwachung bei im Vergleich zu herkömmlichen Isolationsüberwachungen reduzierten Herstellungskosten ermöglichen.

Die Erfindung löst diese Aufgabe durch eine Wechselrichterschaltung nach Anspruch 1, einen Wechselrichter nach Anspruch 6 und ein Photovoltaiksystem nach Anspruch 7. Bevorzugte Ausführungsformen sind Gegenstand der Unteransprüche.

Die erfindungsgemäße Wechselrichterschaltung dient zur Umwandlung einer von einem Generator erzeugten Gleichspannung in eine NetzWechselspannung. Die Wechselrichterschaltung beinhaltet eine herkömmliche Brückenschaltung mit ansteuerbaren Schaltmitteln, wobei die Brückenschaltung zwischen ein positives Zwischenkreispotential und ein negatives Zwischenkreispotential eingeschleift ist.

Durch Ansteuern der Schaltmittel wird die Wechselspannung aus der Zwischenkreisspannung an mindestens einem Wechselspannungsausgang erzeugt.

Weiter ist mindestens ein Ausgangsspannungs-Messwiderstand vorgesehen, der zwischen den Wechselspannungsausgang und ein Bezugspotential, insbesondere ein Erdpotential, eingeschleift ist, wobei eine an dem Ausgangsspannungs-Messwiderstand anstehende Spannung den momentanen Wert der Ausgangsspannung darstellt und zu deren Regelung verwendet wird.

Mindestens ein Zwischenkreisspannungs-Messwiderstand ist mit einem Anschluss mit dem Bezugspotential verbunden, wobei eine an dem mindestens einen Zwischenkreisspannungs-Messwiderstand gegen das Bezugspotential gebildete Spannung zur Steuerung des Betriebs der Wechselrichterschaltung, beispielsweise zur Regelung der Zwischenkreisspannung, ausgewertet wird.

Eine Isolationsüberwachungsschaltung der Wechselrichterschaltung ist dazu ausgebildet, einen Isolationsfehler zu detektieren, und beinhaltet eine Spannungsmesseinrichtung, die dazu ausgebildet ist, eine Ist-Spännung in Form einer Potentialdifferenz zwischen einem Zwischenkreispotential, insbesondere dem positiven Zwischenkreispotential, und dem Bezugspotential zu messen, eine Steuereinrichtung, beispielsweise in Form eines Mikrocontrollers oder eines digitalen Signalprozessors (DSP), zur Ansteuerung der Schaltmittel der Brückenschaltung derart, dass während einer Isolationsüberwachung mindestens zwei der folgenden Schaltstellungen A), B) und C) bewirkt werden: A) der Ausgangsspannungs-Messwiderstand ist ausschließlich mit dem positiven Zwischenkreispotential verbunden, B) der Ausgangsspannungs-Messwiderstand ist ausschließlich mit dem negativen Zwischenkreispotential verbunden, und C) der Ausgangsspannungs-Messwiderstand ist weder mit dem positiven noch dem negativen Zwischenkreispotential verbunden, und eine Auswerteeinrichtung, die beispielsweise ebenfalls durch den Mikrocontroller bzw. den DSP verwirklicht sein kann und die dazu ausgebildet ist, die Ist-Spannung mit einer von der Schaltstellung der Schaltmittel abhängigen, vorgegebenen Soll-Spannung zu vergleichen und einen Isolationsfehler anzuzeigen, wenn eine Differenz zwischen der Ist- und der Soll-Spannung ein vorgegebenes Maß überschreitet. Zur Berechnung der Soll-Spannung können Annahmen bezüglich eines Fehlerortes und eines Fehlerwiderstandes getroffen werden.

Da die bereits in der Brückenschaltung vorhandenen Schaltmittel und der ebenfalls bereits vorhandene Ausgangsspannungs-Messwiderstand neben ihrer herkömmlichen Funktion auch dazu verwendet werden, ein Teilerverhältnis eines Spannungsteilers umfassend den oder die Zwischenkreisspannungs-Messwiderstände zu verändern, dessen Teilerspannung(en) zur Isolationsüberwachung ausgewertet werden, können die herkömmlicherweise zusätzlich hierfür verwendeten Widerstände und Schaltmittel entfallen, wodurch die Isolationsüberwachungsschaltung verglichen mit herkömmlichen Lösungen einfacher und kostengünstiger herstellbar ist.

In einer Weiterbildung ist mindestens ein Gleichspannungssteller, beispielsweise ein Hochsetzsteller oder ein Tiefsetzsteller, vorgesehen, der dazu ausgebildet ist, aus der vom Generator erzeugten Gleichspannung eine Zwischenkreisspannung mit geeignetem Pegel zu erzeugen, wobei die Zwischenkreisspannung einer Potentialdifferenz zwischen dem positiven Zwischenkreispotential und dem negativem Zwischenkreispotential entspricht.

In einer Weiterbildung ist die Wechselspannung eine dreiphasige Netzwechselspannung, wobei ein erster Wechselspannungsausgang zur Ausgabe einer ersten Phase der Netzwechselspannung vorgesehen ist, ein zweiter Wechselspannungsausgang zur Ausgabe einer zweiten Phase der Netzwechselspannung vorgesehen ist und ein dritter Wechselspannungsausgang zur Ausgabe einer dritten Phase der Netzwechselspannung vorgesehen ist, wobei ein erster Ausgangsspannungs-Messwiderstand zwischen den ersten Wechselspannungsausgang und das Bezugspotential eingeschleift ist, ein zweiter Ausgangsspannungs-Messwiderstand zwischen den zweiten Wechselspannungsausgang und das Bezugspotential eingeschleift ist und ein dritter Ausgangsspannungs-Messwiderstand zwischen den dritten Wechselspannungsausgang und das Bezugspotential eingeschleift ist.

In einer Weiterbildung ist der Generator ein photovoltaischer Generator (PV-Generator).

In einer Weiterbildung sind die Schaltmittel insulated gate bipolar Transistoren (IGBTs).

Die Erfindung wird nachfolgend unter Bezugnahme auf die Zeichnung beschrieben, die bevorzugte Ausführungsformen der Erfindung darstellt. Hierbei zeigt schematisch:

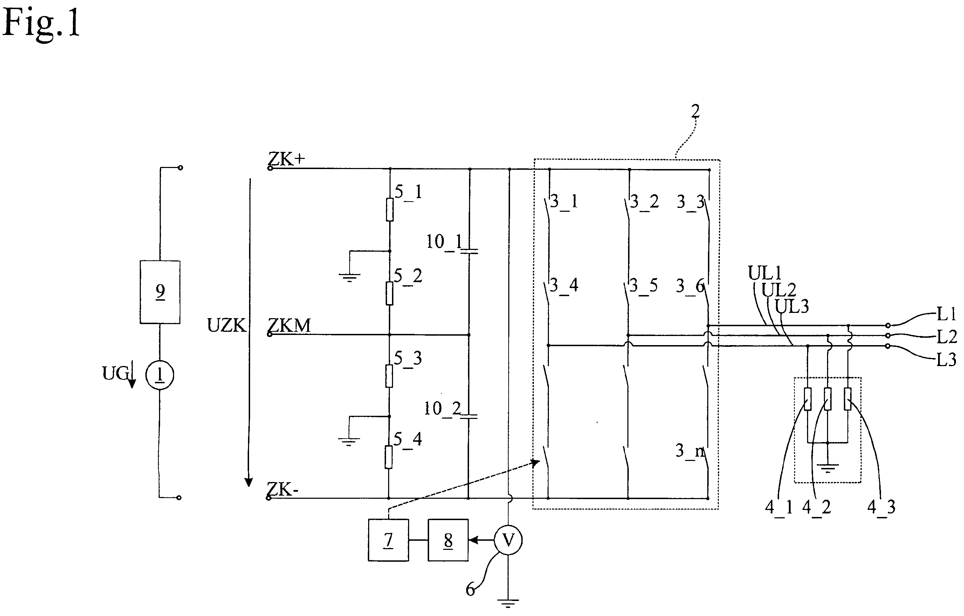

- Fig. 1: eine Wechselrichterschaltung mit erfindungsgemäßer Isolationsüberwachung.

Fig. 1 zeigt eine Wechselrichterschaltung als Bestandteil eines Wechselrichters zur Umwandlung einer von einem PV-Generator 1 erzeugten Gleichspannung UG in eine dreiphasige Netzwechselspannung UL1, UL2 und UL3. Exemplarisch ist lediglich ein einzelner, so genannter Solargeneratorstrang mit dem PV-Generator 1 dargestellt. Es versteht sich, dass auch mehr als ein Solargeneratorstrang vorhanden sein kann, d.h. die Wechselrichterschaltung kann auch Bestandteil eines so genannten Multistrangwechselrichters sein.

Ein erster Wechselspannungsausgang L1 dient zur Ausgabe einer ersten Phase UL1 der Netzwechselspannung, ein zweiter Wechselspannungsausgang L2 dient zur Ausgabe einer zweiten Phase UL2 der Netzwechselspannung und ein dritter Wechselspannungsausgang L3 dient zur Ausgabe einer dritten Phase UL3 der Netzwechselspannung.

Zwischen die Wechselspannungsausgänge L1 bis L3 und ein nicht dargestelltes Wechselspannungsnetz ist weiterhin ein herkömmlicher, dreiphasiger Netztrennungsschalter eingeschleift, der bei einer Isolationsüberprüfung geöffnet ist, um die Wechselspannungsausgänge L1 bis L3 vom Netzwechselspannungsnetz zu trennen. Erst nach erfolgreicher Isolationsüberprüfung wird der Netztrennungsschalter geschlossen, wodurch eine Einspeisung der durch den PV-Generator 1 umgewandelten Solarenergie in das Wechselspannungsnetz möglich wird.

Ausgangsspannungs-Messwiderstände 4_1, 4_2 und 4_3 sind zwischen die zugehörigen Wechselspannungsausgänge L1, L2 bzw. L3 und ein Bezugspotential in Form von Prozesserde PE eingeschleift. Die Ausgangsspannungs-Messwiderstände 4_1, 4_2 und 4_3 dienen herkömmlich zur AC-Spannungsmessung der einzelnen Phasen UL1, UL2 und UL3.

Die Wechselrichterschaltung enthält weiter eine herkömmliche Brückenschaltung 2 mit ansteuerbaren Schaltmitteln in Form von IGBTs 3_1 bis 3_n in der dargestellten Topologie, wobei die Brückenschaltung zwischen ein positives Zwischenkreispotential ZK+ und ein negatives Zwischenkreispotential ZK- eingeschleift ist und durch geeignetes Ansteuern der IGBTs 3_1 bis 3_n die dreiphasige Netzwechselspannung UL1, UL2 und UL3 erzeugt. Die IGBTs 3_1 bis 3_n können beispielsweise von einem herkömmlichen, nicht gezeigten DSP angesteuert werden.

Zwischen das positive Zwischenkreispotential ZK+ und das negative Zwischenkreispotential ZK- sind Zwischenkreiskondensatoren 10_1 und 10_2 eingeschleift, wobei an einem Verbindungsknoten der beiden Zwischenkreiskondensatoren 10_1 und 10_2 ein Mitten-Zwischenkreispotential ZKM ansteht.

Ein Gleichspannungssteller 9 dient dazu, aus der vom PV-Generator 1 erzeugten Gleichspannung UG eine Zwischenkreisspannung UZK zu erzeugen, die einer Potentialdifferenz zwischen dem positiven Zwischenkreispotential ZK+ und dem negativem Zwischenkreispotential ZKentspricht.

Zwischenkreisspannungs-Messwiderstände 5_1, 5_2, 5_3 und 5_4 sind in Serie zwischen das positive Zwischenkreispotential ZK+ und das negative Zwischenkreispotential ZK- eingeschleift, wobei ein Verbindungsknoten der Zwischenkreisspannungs-Messwiderstände 5_1 und 5_2 und ein Verbindungsknoten der Zwischenkreisspannungs-Messwiderstände 5_3 und 5_4 jeweils mit PE verbunden ist und ein Verbindungsknoten der Zwischenkreisspannungs-Messwiderstände 5_2 und 5_3 mit dem Verbindungsknoten der beiden Zwischenkreiskondensatoren 10_1 und 10_2 verbunden ist. Die an den Zwischenkreisspannungs-Messwiderständen 5_1, 5_2, 5_3 und 5_4 anstehenden Spannungen gegen PE werden herkömmlich zur Steuerung des Betriebs der Wechselrichterschaltung ausgewertet.

Weiter ist eine Isolationsüberwachungsschaltung vorgesehen, die dazu dient, einen Isolationsfehler, d.h. eine ungewollte, niederohmige Verbindung mit PE innerhalb der Wechselrichterschaltung, zu detektieren.

Die Isolationsüberwachungsschaltung umfasst hierzu eine Spannungsmesseinrichtung 6, die dazu ausgebildet ist, eine Ist-Spannung in Form einer Potentialdifferenz zwischen dem positiven Zwischenkreispotential ZK+ und PE zu messen.

Weiter umfasst die Isolationsüberwachungsschaltung eine Steuereinrichtung 7 zur Ansteuerung der IGBTs 3_1 bis 3_n der Brückenschaltung 2 derart, dass während einer Isolationsüberwachung mindestens zwei, bevorzugt alle drei, der folgenden Schaltstellungen bewirkt bzw. eingestellt werden: sämtliche Ausgangsspannungs-Messwiderstände 4_1, 4_2 und 4_3 sind ausschließlich mit dem positiven Zwischenkreispotential ZK+ verbunden, sämtliche Ausgangsspannungs-Messwiderstände 4_1, 4_2 und 4_3 sind ausschließlich mit dem negativen Zwischenkreispotential ZK- verbunden und sämtliche Ausgangsspannungs-Messwiderstände 4_1, 4_2 und 4_3 sind weder mit dem positiven noch dem negativen Zwischenkreispotential ZK+ bzw. ZKverbunden. Die Steuereinrichtung 7 kann als Mikrocontroller oder DSP realisiert sein, wobei der Mikrocontroller bzw. der DSP gleichzeitig auch zur Ansteuerung der IGBTs 3_1 bis 3_n im normalen Betrieb der Wechselrichterschaltung dienen kann.

Weiter umfasst die Isolationsüberwachungsschaltung eine Auswerteeinrichtung 8, die dazu dient, die Ist-Spannung mit einer von der Schaltstellung der IGBTs 3_1 bis 3_n abhängigen, vorgegebenen Soll-Spannung zu vergleichen und einen Isolationsfehler anzuzeigen, wenn eine Differenz zwischen der Ist- und der Soll-Spannung ein vorgegebenes Maß überschreitet. Zur Vorausberechnung der Soll-Spannung werden Annahmen bezüglich des Fehlerortes und des Fehlerwiderstandes getroffen.

Zusammenfassend basiert die Erfindung auf folgenden Überlegungen:

Der zu detektierende Isolationsfehler kann als ein einzelner Fehlerwiderstand vom PV-Generator 1 oder ZK+ nach PE abgebildet werden, der einen beliebigen Wert annehmen kann. Der Fehlerwiderstand ist zu bestimmen und bei einem zu kleinen Wert ein entsprechender Isolationsfehler auszugeben.

Über einen Spannungsteiler umfassend unter anderem die Zwischenkreisspannungs-Messwiderstände 5_1, 5_2, 5_3 und 5_4 wird herkömmlich ein hochohmiger Bezug zu PE hergestellt. Entspricht die Spannungsaufteilung am Spannungsteiler dem an sich bekannten Widerstandsverhältnis, liegt kein Isolationsfehler vor.

Ein Teil der Widerstände des Spannungsteilers werden über die Messwiderstände 5_1, 5_2, 5_3 und 5_4 realisiert, die im Betreib des Wechselrichters zur Regelung der Zwischenkreisspannung und der Gleichspannungssteller notwendig sind.

Isolationsfehler können jedoch nur dann detektiert werden, wenn durch den Fehlerwiderstand ein Mindeststrom fließt. Beträgt die Spannung am Fehlerort gegen PE etwa Null Volt, fließt kein Strom und der Fehler kann systematisch nicht detektiert werden. Daher ist es notwendig, das Teilerverhältnis des Spannungsteilers durch Zuschalten von Widerständen geeignet zu variieren, um dadurch eine Potentialverschiebung des Zwischenkreises gegenüber PE zu bewirken.

Zum Variieren des Spannungsteilerverhältnisses werden die Widerstände 4_1, 4_2 und 4_3 der AC-Spannungsmessung des Wechselrichters verwendet, die über die IGBTs 3_1 bis 3_n der Brückenschaltung 2 jeweils mit ZK+ bzw. ZK- gekoppelt werden. Zwischen jeder Variation wird die zuvor errechnete, sich theoretisch einstellende Soll-Spannung mit der tatsächlichen realen Ist-Spannung verglichen. Diese Spannungsmessung ist zwischen ZK+ und PE vorgesehen.

Die Gesamtsteuerung erfolgt über einen Algorithmus in der Software des Wechselrichters. Durch die Variation des Spannungsteilers können Isolationsfehler in jedem Bereich des Generators sicher erkannt werden, wobei zur Variation keine dedizierten, zusätzlichen Bauelemente wie bei herkömmlichen Lösungen erforderlich sind, da bereits vorhandene Bauelemente mitverwendet werden.

## Patentansprüche

1. Wechselrichterschaltung zur Umwandlung einer von einem Generator (1) erzeugten Gleichspannung (UG) in eine Wechselspannung (UL1, UL2, UL3), mit
- einer Brückenschaltung (2) mit ansteuerbaren Schaltmitteln (3_1~3_n), wobei die Brückenschaltung zwischen ein positives Zwischenkreispotential (ZK+) und ein negatives Zwischenkreispotential (ZK-) eingeschleift ist und durch Ansteuern der Schaltmittel die Wechselspannung an mindestens einem Wechselspannungsausgang (L1, L2, L3) erzeugt,
- mindestens einem Zwischenkreisspannungs-Messwiderstand (5_1, 5_2, 5_3, 5_4), der mit einem Anschluss mit dem Bezugspotential verbunden ist, wobei eine an dem mindestens einen Zwischenkreisspannungs-Messwiderstand anstehende Spannung zur Steuerung des Betriebs der Wechselrichterschaltung ausgewertet wird, und
- einer Isolationsüberwachungsschaltung, die dazu ausgebildet ist, einen Isolationsfehler zu detektieren, mit
- einer Spannungsmesseinrichtung (6), die dazu ausgebildet ist, eine Ist-Spannung in Form einer Potentialdifferenz zwischen einem Zwischenkreispotential, insbesondere dem positiven Zwischenkreispotential, und dem Bezugspotential zu messen, **gekennzeichnet durch**
- mindestens einen Ausgangsspannungs-Messwiderstand (4_1, 4_2, 4_3), der zwischen den Wechselspannungsausgang und ein Bezugspotential, insbesondere ein Erdpotential, eingeschleift ist, und dass die Isolationsüberwachungsschaltung weiter
- eine Steuereinrichtung (7) umfasst zur Ansteuerung der Schaltmittel der Brückenschaltung derart, dass während einer Isolationsüberwachung mindestens zwei der folgenden Schaltstellungen bewirkt werden:
- der Ausgangsspannungs-Messwiderstand ist ausschließlich mit dem positiven Zwischenkreispotential verbunden,
- der Ausgangsspannungs-Messwiderstand ist ausschließlich mit dem negativen Zwischenkreispotential verbunden, und
- der Ausgangsspannungs-Messwiderstand ist weder mit dem positiven noch dem negativen Zwischenkreispotential verbunden, und
- eine Auswerteeinrichtung (8), die dazu ausgebildet ist, die Ist-Spannung mit einer von der Schaltstellung der Schaltmittel abhängigen, vorgegebenen Soll-Spannung zu vergleichen und einen Isolationsfehler anzuzeigen, wenn eine Differenz zwischen der Ist- und der Soll-Spannung ein vorgegebenes Maß überschreitet, umfasst.

2. Wechselrichterschaltung nach Anspruch 1, **gekennzeichnet durch** mindestens einen Gleichspannungssteller (9), der dazu ausgebildet ist, aus der vom Generator erzeugten Gleichspannung eine Zwischenkreisspannung (UZK) zu erzeugen, die einer Potentialdifferenz zwischen dem positiven Zwischenkreispotential und dem negativem Zwischenkreispotential entspricht.

3. Wechselrichterschaltung nach Anspruch 1 oder 2, **dadurch gekennzeichnet, dass** die Wechselspannung eine dreiphasige Netzwechselspannung ist, wobei ein erster Wechselspannungsausgang (L1) zur Ausgabe einer ersten Phase (UL1) der Netzwechselspannung vorgesehen ist, ein zweiter Wechselspannungsausgang (L2) zur Ausgabe einer zweiten Phase (UL2) der Netzwechselspannung vorgesehen ist und ein dritter Wechselspannungsausgang (L3) zur Ausgabe einer dritten Phase (UL3) der Netzwechselspannung vorgesehen ist, wobei ein erster Ausgangsspannungs-Messwiderstand (4_1) zwischen den ersten Wechselspannungsausgang und das Bezugspotential eingeschleift ist, ein zweiter Ausgangsspannungs-Messwiderstand (4_2) zwischen den zweiten Wechselspannungsausgang und das Bezugspotential eingeschleift ist und ein dritter Ausgangsspannungs-Messwiderstand (4_3) zwischen den dritten Wechselspannungsausgang und das Bezugspotential eingeschleift ist.

4. Wechselrichterschaltung nach einem der vorhergehenden Ansprüche, **dadurch gekennzeichnet, dass** der Generator ein photovoltaischer Generator ist.

5. Wechselrichterschaltung nach einem der vorhergehenden Ansprüche, **dadurch gekennzeichnet, dass** die Schaltmittel insulated gate bipolar Transistoren sind.

6. Wechselrichter, **dadurch gekennzeichnet, dass** er eine Wechselrichterschaltung nach einem der Ansprüche 1 bis 5 aufweist.

7. Photovoltaiksystem, mit
- mindestens einem PV-Generator und
- einem dem mindestens einen PV-Generator zugeordneten Wechselrichter nach Anspruch 6.

## Claims

1. Inverter circuit for transformation of a direct voltage (UG) generated by a generator (1) to an alternating voltage (UL1, UL2, UL3), comprising
- a bridge circuit (2) including controllable switching means (3_1 ~ 3_n), wherein the bridge circuit is connected between a positive intermediate circuit potential (ZK+) and a negative intermediate circuit potential (ZK-) and generates the alternating voltage on at least one alternating voltage output (L1, L2, L3) by controlling the switching means,
- at least one intermediate circuit voltage measuring resistor (5_1, 5_2, 5_3, 5_4) with one terminal thereof connected to a reference potential, wherein a voltage applied to the at least one intermediate circuit voltage measuring resistor is evaluated for controlling operation of the inverter circuit, and
- an insulation monitoring circuit arranged to detect an insulation fault, comprising
- a voltage metering device (6) arranged to measure an actual voltage in the form of a potential difference between an intermediate circuit potential, in particular the positive intermediate circuit potential, and the reference potential,
**characterized**
- **by** at least one output voltage measuring resistor (4_1, 4_2, 4_3) connected between the alternating voltage output and the reference potential, in particular a ground potential, and
- in that the insulation monitoring circuit further comprises
- a control device (7) for controlling the switching means of the bridge circuit such that during an insulation monitoring at least two of the following switching positions are caused:
- the output voltage measuring resistor is connected exclusively to the positive intermediate circuit potential,
- the output voltage measuring resistor is connected exclusively to the negative intermediate circuit potential, and
- the output voltage measuring resistor is connected to neither the positive nor the negative intermediate circuit potential, and
- an evaluation device (8) arranged to compare the actual voltage to a predetermined set voltage, the set voltage being dependent from the switching position of the switching means, and to indicate an insulation fault, if a difference between the actual voltage and the set voltage exceeds a predetermined amount.

2. Inverter circuit according to claim 1, **characterized by** at least one direct voltage actuator (9) arranged to generate an intermediate circuit voltage (UZK) from the direct voltage generated by the generator, said intermediate circuit voltage (UZK) corresponding to a potential difference between the positive intermediate circuit potential and the negative intermediate circuit potential.

3. Inverter circuit according to claim 1 or 2, **characterized in that** the alternating voltage is a three-phase mains alternating voltage, wherein a first alternating voltage output (L1) is provided for outputting a first phase (UL1) of the mains alternating voltage, a second alternating voltage output (L2) is provided for outputting a second phase (UL2) of the mains alternating voltage, and a third alternating voltage output (L3) is provided for outputting a third phase (UL3) of the mains alternating voltage, wherein a first output voltage measuring resistor (4_1) is connected between the first alternating voltage output and the reference potential, a second output voltage measuring resistor (4_2) is connected between the second alternating voltage output and the reference potential, and a third output voltage measuring resistor (4_3) is connected between the third alternating voltage output and the reference potential.

4. Inverter circuit according to any of the preceding claims, **characterized in that** the generator is a photovoltaic generator.

5. Inverter circuit according to any of the preceding claims, **characterized in that** the switching means are insulated gate bipolar transistors.

6. Inverter device, **characterized in that** the device includes an inverter circuit according to any of claims 1 to 5.

7. Photovoltaic system, comprising
- at least one photovoltaic (PV) generator, and
- an inverter device according to claim 6 assigned to the at least one PV generator.

## Revendications

1. Circuit onduleur destiné à convertir une tension continue (UG) générée par un générateur (1) en une tension alternative (UL1, UL2, UL3), comprenant
- un circuit en pont (2) doté de moyens de commutation commandables (3_1~3_n), le circuit en pont étant bouclé en ligne entre un potentiel de circuit intermédiaire positif (ZK+) et un potentiel de circuit intermédiaire négatif (ZK-) et générant la tension alternative sur au moins une sortie de tension alternative (L1, L2, L3) en commandant les moyens de commutation,
- au moins une résistance de mesure de tension de circuit intermédiaire (5_1, 5_2, 5_3, 5_4), laquelle est reliée par une borne au potentiel de référence, une tension produite aux bornes de l'au moins une résistance de mesure de tension de circuit intermédiaire étant interprétée pour commander le fonctionnement du circuit onduleur, et
- un circuit de surveillance d'isolation qui est configuré pour détecter un défaut d'isolation, comprenant
- un dispositif de mesure de tension (6) qui est configuré pour mesurer une tension réelle sous la forme d'une différence de potentiel entre un potentiel de circuit intermédiaire, notamment le potentiel de circuit intermédiaire positif, et le potentiel de référence,
**caractérisé par** au moins une résistance de mesure de tension de sortie (4_1, 4_2, 4_3), laquelle est bouclée en ligne entre la sortie de tension alternative et un potentiel de référence, notamment un potentiel de terre, et en ce que le circuit de surveillance d'isolation comprend en outre
- un dispositif de commande (7) destiné à commander les moyens de commutation du circuit en pont de telle sorte que pendant une surveillance de l'isolation, au moins deux des positions de commutation suivantes sont obtenue :
- la résistance de mesure de tension de sortie est exclusivement reliée au potentiel de circuit intermédiaire positif,
- la résistance de mesure de tension de sortie est exclusivement reliée au potentiel de circuit intermédiaire négatif, et
- la résistance de mesure de tension de sortie n'est reliée ni au potentiel de circuit intermédiaire positif, ni au potentiel de circuit intermédiaire négatif, et
- comprend un dispositif d'interprétation (8) qui est configuré pour comparer la tension réelle avec une tension de consigne prédéfinie dépendante de la position de commutation des moyens de commutation et pour indiquer une erreur d'isolation lorsqu'une différence entre la tension réelle et la tension de consigne dépasse une valeur prédéfinie.

2. Circuit onduleur selon la revendication 1, **caractérisé par** au moins un organe de réglage de tension continue (9) qui est configuré pour générer une tension de circuit intermédiaire (UZK) à partir de la tension continue générée par le générateur, laquelle correspond à une différence de potentiel entre le potentiel de circuit intermédiaire positif et le potentiel de circuit intermédiaire négatif.

3. Circuit onduleur selon la revendication 1 ou 2, **caractérisé en ce que** la tension alternative est une tension alternative de réseau triphasée, une première sortie de tension alternative (L1) étant prévue pour délivrer une première phase (UL1) de la tension alternative de réseau, une deuxième sortie de tension alternative (L2) étant prévue pour délivrer une deuxième phase (UL2) de la tension alternative de réseau et une troisième sortie de tension alternative (L3) étant prévue pour délivrer une troisième phase (UL3) de la tension alternative de réseau, une première résistance de mesure de tension de sortie (4_1) étant bouclée en ligne entre la première sortie de tension alternative et le potentiel de référence, une deuxième résistance de mesure de tension de sortie (4_2) étant bouclée en ligne entre la deuxième sortie de tension alternative et le potentiel de référence et une troisième résistance de mesure de tension de sortie (4_3) étant bouclée en ligne entre la troisième sortie de tension alternative et le potentiel de référence.

4. Circuit onduleur selon l'une des revendications précédentes, **caractérisé en ce que** le générateur est un générateur photovoltaïque.

5. Circuit onduleur selon l'une des revendications précédentes, **caractérisé en ce que** les moyens de commutation sont des transistors bipolaires à gâchette isolée.

6. Onduleur, **caractérisé en ce qu'**il possède un circuit onduleur selon l'une des revendications 1 à 5.

7. Système photovoltaïque comprenant
- au moins un générateur photovoltaïque et
- un onduleur selon la revendication 6 associé à l'au moins un générateur photovoltaïque.
